(19) **Europäisches Patentamt / European Patent Office / Office européen des brevets**

(11) **EP 4 307 498 A1**

(12) # EUROPEAN PATENT APPLICATION

(43) Date of publication:
**17.01.2024 Bulletin 2024/03**

(21) Application number: **23184367.3**

(22) Date of filing: **10.07.2023**

(51) International Patent Classification (IPC):
*H01S 5/14* (2006.01)   *H01S 5/183* (2006.01)
*H01S 3/08022* (2023.01)   *H01S 3/08* (2023.01)
*H01S 3/105* (2006.01)   *H01S 3/109* (2006.01)
*H01S 5/024* (2006.01)   *H01S 5/04* (2006.01)
*H01S 3/081* (2006.01)   *H01S 3/082* (2006.01)
*H01S 3/083* (2006.01)

(52) Cooperative Patent Classification (CPC):
**H01S 5/142; H01S 5/18361;** H01S 3/08027;
H01S 3/08054; H01S 3/0815; H01S 3/082;
H01S 3/083; H01S 3/105; H01S 3/109;
H01S 5/02476; H01S 5/041; H01S 5/141;
H01S 2301/163

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **15.07.2022 US 202263389809 P**

(71) Applicant: **Thorlabs GmbH**
**85232 Bergkirchen (DE)**

(72) Inventors:
- **Wollenzin, Jörn**
  **23568 Lübeck (DE)**
- **Dühn, Johannes**
  **23552 Lübeck (DE)**
- **Verges, Michael**
  **24539 Neumünster (DE)**
- **Kirchner, Matt**
  **CO 80020 Westminster (DE)**

(74) Representative: **Grättinger Möhring von Poschinger**
**Patentanwälte Partnerschaft mbB**
**Wittelsbacherstrasse 2b**
**82319 Starnberg (DE)**

(54) **THREE-MIRROR-CAVITY SINGLE LONGITUDINAL MODE SEMICONDUCTOR MEMBRANE EXTERNAL CAVITY SURFACE EMITTING LASER**

(57) A tunable laser including: an optical cavity including a first and second end mirrors (306, 307), and a center mirror (302); a quantum well gain region (301) between the end mirrors (306, 307); and a transparent heat spreader (304) bonded to the quantum well gain region (301); wherein the optical cavity is configured to generate resonant laser radiation between the end mirrors (306, 307); the quantum well gain region (301) includes at least one quantum well (303) that is substantially aligned with an antinode of the resonant laser radiation and is located at a fixed distance to the center mirror (302); the distance (308) from the first end mirror (306) to the center mirror (302) is optimized to maintain maximum output power, and the distance (309) from the second end mirror (307) to the center mirror (302) is adjustable for tuning the laser to a desired output wavelength; the center mirror (302) maintains an antinode of the resonant radiation at a fixed phase relationship with the center mirror (302).

FIG. 7A

**Description**

**CROSS REFERENCE TO RELATED APPLICATIONS**

This application claims the benefit of U.S. Provisional Patent Application No. 63/389,809 filed on July 15, 2022. The disclosure and entire teachings of U.S. Provisional Patent Application 63/340,164 are hereby incorporated by reference.

**TECHNICAL FIELD**

The present disclosure relates to external cavity surface emitting lasers, and more specifically to a three-mirror-cavity single longitudinal mode semiconductor membrane external cavity surface emitting laser.

**BACKGROUND**

In the recent years, an emerging interest in the field of quantum technology and ultracold atoms has increased the demand for very stable laser that are linked to atomic and ion transitions. So far, this interest has mainly been served by amplified external cavity, electrically pumped edge emitting semiconductor lasers. This technology requires very small apertures in the semiconductor material to enable transverse single mode operations. Hence, power scaling of these devices is limited to the power density acceptance of the gain elements.

To overcome this power limit, optically pumped surface emitting devices have been proposed and implemented. In these devices, several quantum well layers, embedded between barrier layers, are excited by optical radiation and a laser resonator is constructed at a significant angle of incidence to these quantum well layers, typically 90°. Opposed to edge emitting laser gain material, the lateral mode of the resonant laser beam is not controlled by the material containing the optical gain, but solely by an external cavity. This technology allows much larger apertures to be realized in the gain material and hence up-scaling of the power density.

The technology of optically pumped vertical emission of semiconductor material is realized in the configurations VCSEL, VECSEL and MECSEL. In VCSEL (vertical cavity surface emitting laser) devices, the cavity is formed in a monolithic device. To limit the laser to longitudinal single frequency operation, the optical cavity length $n_g L$ ($n_g$ being the group index) is designed, so that the free spectral range exceeds the gain bandwidth $\Delta\lambda_{gain}$:

$$\Delta\lambda_{gain} < \frac{\lambda_{center}^2}{n_g L}$$

Since the gain bandwidth of semiconductor lasers is much larger than that of doped solid-state lasers, typical optical cavity lengths are in the order of < 50 μm, which limits the lateral area, in which the laser can operate in fundamental transverse mode. VECSEL (vertical external cavity surface emitting-laser) and MECSEL (semiconductor membrane external cavity surface emitting laser) utilize a laser cavity that extends beyond the element that provides the optical gain. A VECSEL provides one cavity mirror in close contact to the gain structure. In a MECSEL configuration, all cavity mirrors can be placed at a substantial distance to the element providing optical gain. The external cavity configurations allow for cavity designs that both limit the laser transverse mode to the fundamental one. But it requires further cavity elements to limit such laser configurations to single longitudinal mode operation.

Since VECSEL and MECSEL technology extend the laser cavity length into the environment surrounding the gain and mirror structure, efficient intra-cavity frequency conversion like second harmonic generation is possible (see Ref. [2]).

Advantages of MECSEL technology

In a typical VECSEL setup, the VECSEL chip includes both layers that provide optical gain and Bragg mirror. This mirror in most cases is used as a cavity end mirror. In contrast, a MECSEL chip also contains layers that provide optical gain, but there are no Bragg mirror structures attached to the gain structure. The gain element is attached to a transparent heat spreading material (silicon carbide, preferred) on either one or both surfaces. Using suitable silicon carbide wafer material, direct bonding of the multi-quantum-well structure to the transparent heat spreader is feasible only with cleaning and activation steps necessary. As opposed to Ref. [6], where the use of single piece diamonds is proposed in combination with laser schemes differing from this disclosure, the process can very efficiently be performed on wafer scale. For example, 100 mm diameter processing has shown very high yield.

A VECSEL utilizes one of the Fabry Perot laser cavity end mirror being epitaxially grown and in direct contact to the gain structure of the laser. The materials available for these mirrors (for instance, GaAs, AlAs and InP, GaInAsP) have a low contrast of refractive index when compared to typical dielectric oxide and fluoride materials commonly used in free-space laser cavities (for instance, $SiO_2$, $Al_2O_3$, $MgF_2$, $Ti_2O5$, $Ta_2O_5$). Oxidization of epitaxially grown layers is possible, but this process limits the useable active area.

In typical VECSEL configurations, cooling of the gain medium is performed through the Bragg mirror attached to the gain structure (see Ref. [2]). Due to the larger thermal conductivity of epitaxially grown semiconductor mirrors, these are preferred over dielectric oxide coatings. This limits the technology in terms of available tuning bandwidth.

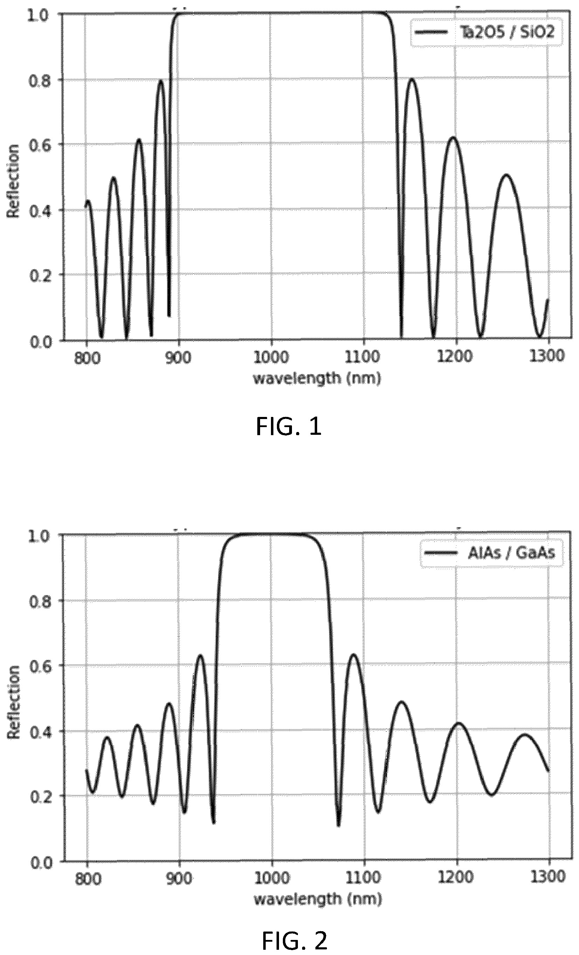

FIG. 1 and FIG. 2 give a comparison of mirror materials commonly used in 1050nm free-space lasers like MECSEL cavities. FIG. 1 depicts the reflectivity of a laser cavity end mirror made of $SiO_2$ and $Ta_2O_5$. In contrast, FIG. 2 shows the reflectivity performance of a cavity end mirror of AlAs and GaAs monolithically grown on top of the quantum well structure, as typically used in a VECSEL. Both cases show a multi-layer Bragg reflector design of 20 pairs of high and low index quarter-wave optical thickness. In these examples, a two-fold increase of available reflectivity bandwidth is reached.

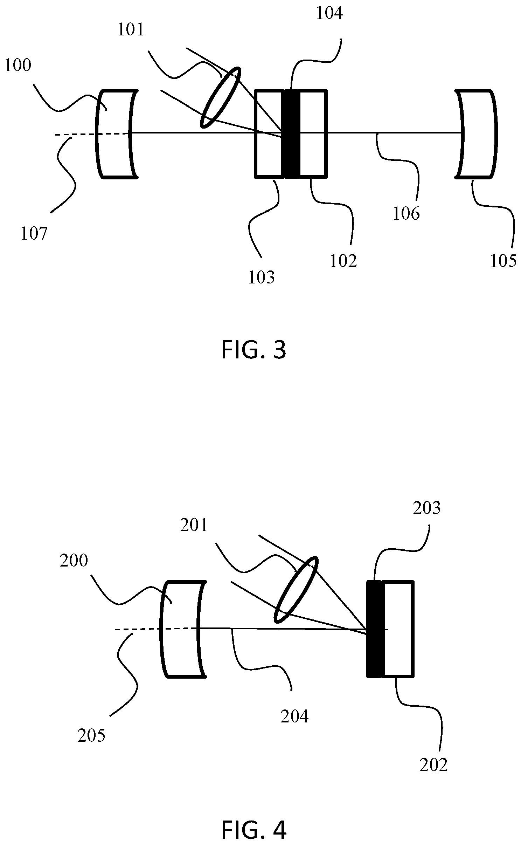

FIG. 3 shows the basic setup of an existing MECSEL device. In the MECSEL schematic shown in FIG. 3, the gain element 104 is optically pumped by pump beam and lens 101 and cooled by transparent heat spreaders 102 and 103. The MECSEL cavity is formed by two dielectric mirrors 100 and 105 and generates a resonant beam 106. A fraction 107 of that beam is coupled out of the cavity by the semi-transparent mirror 100.

FIG. 4 shows the basic setup of an existing VECSEL device. The VECSEL schematic as shown in FIG. 4 depicts a gain element 203 that is optically pumped by pump beam and lens 201 and cooled through the extra-cavity side of the Bragg mirror 202. The laser cavity is formed by this mirror 202 and an out-coupling mirror 200 and generates a resonant beam 204. A fraction 205 of that beam is coupled out of the cavity by the semi-transparent mirror 200. The VECSEL setup can be operated with an additional intra-cavity heat spreader, or with non-linear out-coupling (for instance, second harmonic generation, see Ref. [2]).

A further advantage of MECSEL technology is the low complexity of wafer-scale processing at low cost. Processing only the gain structure without a Bragg mirror preserves a very good surface quality of the epitaxially grown material and allows for wafer-scale bonding of the gain material to a suitable transparent heat spreader by optical contacting, where Van-der-Waals forces form a rigid contact.

Challenges of MECSEL single frequency tunable laser design

MECSEL technology has some unique advantages over VECSEL technology, the most prominent being the efficient use of conventionally coated dielectric broadband Bragg reflectors, leading to broad tunability and ability to create short mode-locked pulses, and efficient wafer-scale production. Both technologies utilize quantum wells, which in standing wave resonators are most efficiently utilized if the antinodes of the laser standing wave pattern are aligned with the quantum well positions. A disadvantage of MECSEL is the (in comparison with VECSEL) un-controlled phase relation of quantum wells with respect to the standing wave pattern of the laser radiation as defined by the cavity mirrors. A typical VECSEL design is optimized to have the standing wave antinodes and quantum wells overlap (see Ref. [3]). Since the quantum well structure is located very close to one cavity end mirror, this condition can be fulfilled quite well within the tuning range of the device, though the device show some spectral filtering introduced by the sub-cavity around the quantum well structure.

Existing frequency selection schemes like birefringent filters and etalons (see Ref. [1], Ref. [2] and Ref. [3]) can also be utilized in MECSEL configurations, but do not provide means of controlling the standing wave phase inside the quantum well multilayer structure. As of today, no mode-hop free tuning or long-term mode-hop free operation of a standing wave MECSEL has been published. The problem can be circumvented by using travelling wave resonators. Due to the small optical gain of the semiconductor surface emitters, and the relatively large absorption of optical diodes necessary for unidirectional lasing, simple existing schemes of travelling wave single frequency lasers cannot be used in an efficient manner. Ref. [6] suggests a method of using a stabilized passive ring resonator coupled to the active laser ring. Using this method, the effective absorption loss to the active cavity can be minimized. An embodiment of the present disclosure provides a trade-off of between loss for the unwanted direction of laser radiation with the effective absorption loss of the Faraday element. In contrast to an embodiment of the present disclosure, the proposed method in Ref. [6] suggests a comparably complex laser design with obvious restrictions in minimum footprint of the laser and cost.

Continuous tuning to any wavelength within the gain bandwidth, and mode-hop prevention during long term operation, requires additional control features. Ref. [4] suggests that "the gain structure in MECSELs can be placed anywhere inside the cavity". However, simulations and tests with standing wave cavities have shown that this is not the case if the laser needs to be continuously tuned without flipping from one single longitudinal mode to another.

Existing setups utilize AR coated MECSEL chips (see Ref. [1] and Ref. [4]), where the average wavelength can be tuned by a birefringent filter, but they do not show single frequency operation with mode-hop free tuning. These setups do not control the distance of the MECSEL element to the cavity end mirrors, though.

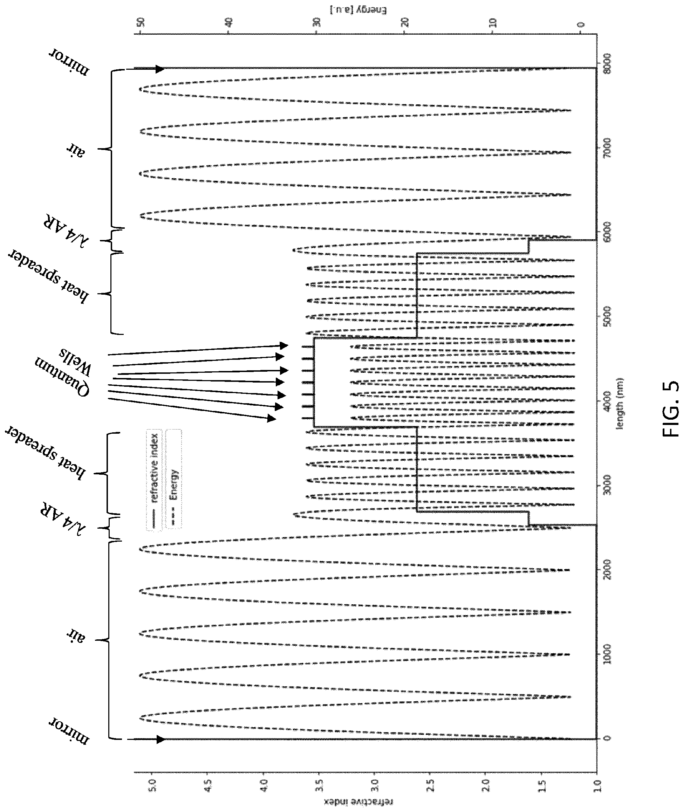

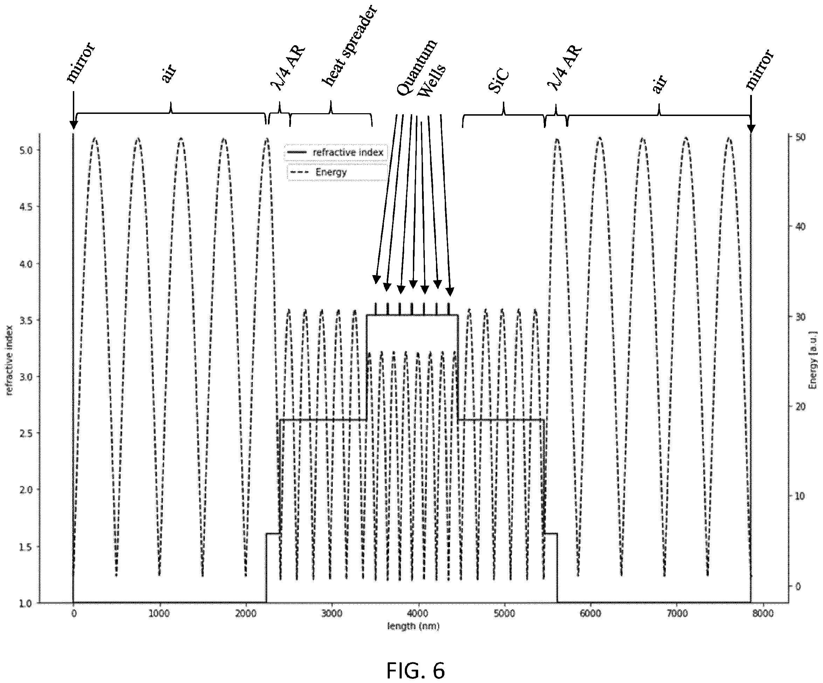

Results of a simulation of the standing wave pattern inside a MECSEL cavity are depicted in FIG. 5 and FIG. 6. This simulation assumes that spectral narrowing is performed by existing technology like birefringent filters, multi-layer coatings and Fabry-Perot etalons (filter elements not shown). In FIGS. 5 and 6, the refractive indices and absolute value of the energy over the cavity are plotted. For better visibility, the structure of the MECSEL chips is shown simplified to AR coating, transparent heat spreaders (SiC in this case), absorbing crystalline barrier layers and quantum wells. Typical MECSEL total optical cavity lengths in air are in the range of 5 mm to 400 mm. For better readability of the plot, the cavity path through air is simulated much shorter. Also, the cavity end mirrors, which typically are dielectric multi-layer Bragg reflectors, are simplified to single high refractive index interfaces. The absolute value (a.u.) of the resonant laser radiation Energy inside the cavity is plotted over the refractive index structure.

Existing comparable cavities that do not contain MECSEL technology suggest tuning the cavity length by piezo actuation of one cavity end mirror (see for instance Ref. [3]), hence tuning the cavity resonance frequencies. Assuming that the laser cavity is filtered to a single longitudinal mode, the frequency of this single mode changes with the cavity length. In this simulation, the total optical cavity length is supporting resonance of one dedicated frequency. In between the simulation results shown in FIG. 5 and FIG. 6, the position of the gain element with respect to the cavity end mirrors is shifted by A/4 (in air). In FIG. 5, the antinodes of the standing wave pattern of the resonant laser frequency are aligned with the quantum wells, hence providing maximum optical gain to the resonant Energy. In FIG. 6, the nodes of the resonant frequency align with the quantum well positions, hence providing minimal optical gain. Realistic filter methods only provide limited suppression of alternative longitudinal modes in MECSEL configurations. In the case of FIG. 6, not only the output power would be reduced compared to the situation as in FIG. 5, but the low gain provided at the desired wavelength would likely provide a more efficient gain/loss ratio for an alternative wavelength with higher gain, even though the round-trip loss might be higher (due to the frequency selective element).

Presently, no solution to this problem has been published or secured. Techniques of laser output wavelength narrowing and longitudinal mode selection that are used in other laser types do not sufficiently overcome the problem of controlling the resonant phase inside the MECSEL gain element.

Tests have been performed on frequency stabilization techniques known from VECSEL publication (see Ref. [3] and Ref. [5]) like the introduction of one or more etalons in addition to a birefringent filter. These techniques did allow for temporary single frequency operation of a MECSEL device. But lacking a proper method for phase control in the gain and filter elements, mode-hop free tuning could not be reached. Also, the laser was sensitive to environmentally induced changes in optical cavity length.

## SUMMARY

An embodiment of the present disclosure suggests means of introducing a single intra-cavity reflection created at a controlled distance to the quantum well structure. It provides spectral filtering in a three-mirror Fabry Perot cavity while also fixing the antinode positions with respect to the MECSEL gain medium. In an embodiment of the present disclosure, a method of longitudinal mode control and optimization is described, allowing long-term operation of the laser without spontaneous switching to adjacent longitudinal modes ("mode hopping") as well as controlled tuning of the resonant wavelength while maintaining the optimal cavity condition to provide maximum gain/loss ratio for the intended resonant wavelength. The method provides robust filtering that can tolerate parasitic reflections (from AR coatings or surface scatter) with more than 10% of the available gain.

A skilled person in processing MECSEL chips, especially being experienced in performing the bond and further processing of gain material grown on a semiconductor substrate with the transparent heat spreader, would appreciate the unique advantages offered by an embodiment of the present disclosure. Using suitable SiC wafers, all these processes can be performed on wafer scale. In contrast to the methods described by Ref. [6], no additional adhesion layers or polishing steps are required. Since the process is being performed on full SiC wafers rather than single piece diamonds, nearly 100% yield are possible and very efficient use of the wafers surface has been proven. This provides the possibility of efficient production of gain elements for internal and external use. In combination with the proposed method of producing Watt-level single frequency lasers in a simple laser setup, with and without intra-cavity frequency conversion, the technology based on an embodiment of the present disclosure would realize commercial success in the market of atom and ion spectroscopy and cooling.

An embodiment of the present disclosure provides a method that enables the technology of optically pumped MECSEL, with output powers in the Watt regime to be operated in single longitudinal mode (SLM) with narrow line width (< 100kHz) in linear standing wave cavities. The technology described provides means of mode hop prevention in continuous tuning or frequency locked operation. An embodiment of the present disclosure provides a technology to fundamentally overcome the MECSEL disadvantage of un-controlled position of the intra-cavity standing wave pattern with respect to the quantum wells (QW) in the gain structure, while in addition supports mode filtering and mode hop prevention through active stabilization of the resonant mode. Though MECSEL technology has already been published (e.g., see Ref. [1]), tunable and mode-hop free single longitudinal mode operation in linear cavities has not been published so far. An embodiment of the present disclosure is suitable of incorporating other technologies like volume Bragg grating spectral narrowing and efficient intra-cavity frequency conversion, especially second harmonic generation (SHG), suggesting the realization of diode pumped operation of visible, single frequency lasers. For both the use in spectroscopy and for applications atomic and ion cooling, tunability and long-term mode-hop free operation are mandatory.

MECSEL technology provides the ability to gain an output power advantage over the commonly used method of amplifying an external-cavity laser. Overcoming the difficulty of longitudinal mode control enables commercial success this market. An embodiment using a three-mirror cavity with the quantum wells at controlled distance to the center mirror is novel and provides a unique solution to this problem.

An embodiment of the present disclosure provides a tunable laser operative in single longitudinal mode to emit tunable radiation over an output wavelength range, the tunable laser including: an optical cavity including a first end mirror, a second end mirror, and a center mirror; a quantum well gain region interposed between the first and second end mirrors; and a transparent heat spreader bonded to a surface of the quantum well gain region; wherein the optical cavity is configured to generate resonant laser radiation between the first and second end mirrors; wherein the quantum well gain region includes at least one quantum well that is substantially aligned with an antinode of the resonant laser radiation and is located at a fixed distance to the center mirror; wherein an intra-cavity distance from the first end mirror to the center mirror is kept at a resonance position to maintain maximum output power, and the distance from the second end mirror to the center mirror is adjustable for tuning the laser to a desired output wavelength; wherein the center mirror is configured to maintain an antinode of the resonant radiation at a fixed phase relationship with the center mirror.

## BRIEF DESCRIPTION OF THE DRAWINGS

FIG. 1 shows a graph of typical MECSEL mirror reflectivity.

FIG. 2 shows a graph of typical VECSEL mirror reflectivity.

FIG. 3 shows an existing VECSEL setup.

FIG. 4 shows an existing MECSEL setup.

FIG. 5 shows a simulation of the wave pattern for a MECSEL chip with antinodes aligned to QWs.

FIG. 6 shows a simulation of the wave pattern for a MECSEL chip with antinodes not aligned to QWs.

FIG. 7A shows a three-mirror MECSEL cavity with single heat spreader according to an embodiment.

FIG. 7B shows a three-mirror MECSEL cavity with single heat spreader according to an embodiment.

FIG. 8 shows a simulation of the wave pattern for a three-mirror MECSEL with single heat spreader according to an embodiment.

FIG. 9A shows a three-mirror MECSEL cavity with double sided heat spreaders according to an embodiment.

FIG. 9B shows a three-mirror MECSEL cavity with double sided heat spreaders according to an embodiment.

FIG. 10 shows a simulation of the wave pattern for a three-mirror MECSEL cavity with double sided heat spreaders according to an embodiment.

FIG. 11 shows a three-mirror MECSEL with prism tuning and SHG according to an embodiment.

FIG. 12 shows a three-mirror MECSEL with mirror tuning and SHG according to an embodiment.

FIG. 13 shows a three-mirror MECSEL in Littrow configuration according to an embodiment.

FIG. 14 shows a three-mirror MECSEL in hybrid ring cavity configuration according to an embodiment.

FIG. 15 shows the transmission characteristics of three-mirror-MECSEL with birefringent filter according to an embodiment.

## DETAILED DESCRIPTION

The description of illustrative embodiments according to principles of the present disclosure is intended to be read in connection with the accompanying drawings, which are to be considered part of the entire written description. In the description of embodiments of the disclosure herein, any reference to direction or orientation is merely intended for convenience of description and is not intended in any way to limit the scope of the present disclosure. Relative terms such as "lower," "upper," "horizontal," "vertical," "above," "below," "up," "down," "top" and "bottom" as well as derivative thereof (e.g., "horizontally," "downwardly," "upwardly," etc.) should be construed to refer to the orientation as then described or as shown in the drawing under discussion. These relative terms are for convenience of description only and do not require that the apparatus be constructed or operated in a particular orientation unless explicitly indicated as such. Terms such as "attached," "affixed," "connected," "coupled," "interconnected," and similar refer to a relationship wherein structures are secured or attached to one another either directly or indirectly through intervening structures, as well as both movable or rigid attachments or relationships, unless expressly described otherwise. Moreover, the features and benefits of the disclosure are illustrated by reference to the exemplified embodiments. Accordingly, the disclosure expressly should not be limited to such exemplary embodiments illustrating some possible non-limiting combination of features that may exist alone or in other combinations of features; the scope of the disclosure being defined by the claims appended hereto.

This disclosure describes the best mode or modes of practicing the disclosure as presently contemplated. This description is not intended to be understood in a limiting sense, but provides an example presented solely for illustrative purposes by reference to the accompanying drawings to advise one of ordinary skill in the art of the advantages and construction of the certain embodiments. In the various views of the drawings, like reference characters designate like or similar parts.

## (A) Single SiC Three-Mirror Configuration

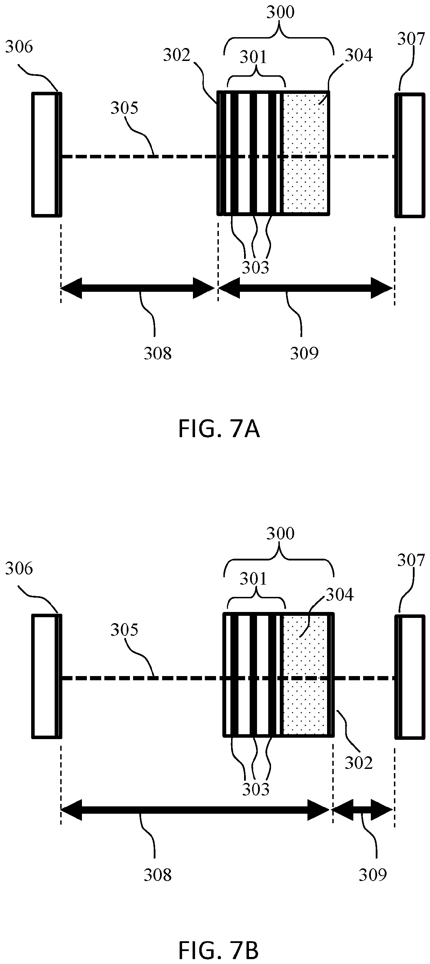

As shown in FIG. 7A, an embodiment of the present disclosure suggests the use of a three-mirror cavity formed by two cavity end mirrors 306 and 307, in which a gain element 300 with a multi-quantum-well structure 301 that is contacted to a transparent heat spreader 304 and has a fixed distance to the center mirror 302 reflection of that three-mirror cavity. A preferred material for the transparent heat spreader is Silicon Carbide (SiC) with high surface quality. A preferred method of contacting the SiC to the multi-quantum-well structure structure is optical (or direct) bonding, without adding an adhesion layer or performing any intermediate polishing steps.

In the multi-quantum-well structure structure 301, the quantum wells 303 are positioned to maximize the overlap of the antinodes of the resonant laser radiation 305. The phase of the antinodes is dominated by the optical distance to the center mirror of the three-mirror cavity. The center mirror has a reflectivity of at least 15% and can be formed by the reflection of the multilayer gain element to the surrounding gas or mixture of gases, which could be modified by an additional thin film coating. Note that the intra-cavity distance between mirrors the first and center mirrors 306, 302 can pass through a gas or mixture of gases, for example: air, Helium, Argon, Nitrogen, etc.

According to one embodiment, FIG. 7B shows an alternative 3-mirror configuration with elements corresponding to those discussed with respect to FIG. 7A.

Note that all interfaces to the surrounding gas or mixture of gases, that are not explicitly identified as one of the three mirrors of our three-mirror-cavity should have a small (<0.5%) reflectivity to avoid parasitic reflexes that would lead to loss of efficiency and reduced reproducibility of wavelength tuning performance of the laser system. The small reflectivity can be achieved by thin-film anti-reflection coating or placement at or close to Brewster angle.

Note that the intra-cavity distance between mirrors the first and center mirrors 306, 302 can pass through a gas or mixture of gases, typically, air, as shown in FIG. 7A. Alternatively, the intra-cavity distance between mirrors the second and center mirrors 307, 302 can pass through a gas or mixture of gases, as shown in FIG. 7B.

One of the intra-cavity distances from cavity end mirror to center mirror 308 and 309 is kept near the ideal resonance position. The resonance position can be optimized by techniques readily established in laser locking applications, for example, by means of phase sensitive extremum seeking control, or other dither locking methods, etc., to maintain maximum output power, while the other distance can be tuned to adjust the laser to the desired output wavelength.

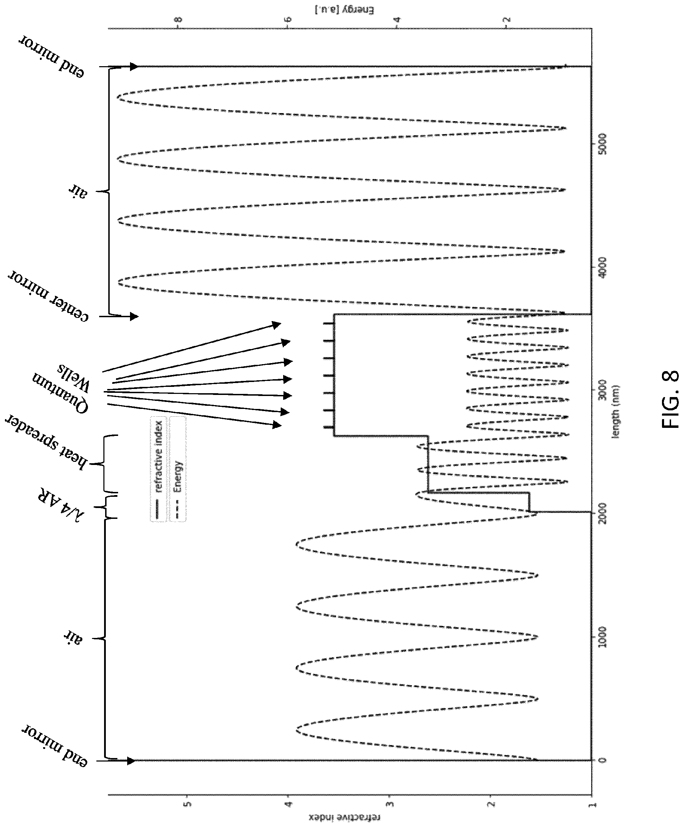

Similar to the simulation results plotted in FIG. 5 and FIG. 6, the phase of the resonant radiation energy absolute value is shown in FIG. 8. In this Figure, the center mirror of the three-mirror cavity enforces an antinode at a fixed phase relationship to that mirror (a node in case of a simple Fresnel reflection).

## (B) Double SiC Sandwich Three-Mirror Configuration

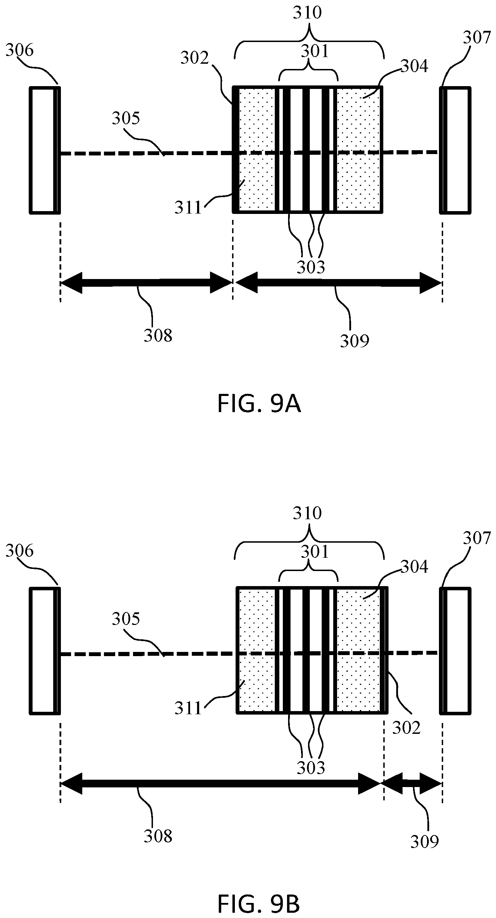

A further configuration according to another embodiment of the present disclosure utilizes a second transparent heat spreader attached to the second surface of the multi-quantum-well structure structure. In this configuration, the center mirror is located at the interface of the second heat spreader to the surrounding gas or mixture of gases. FIG. 9A depicts this configuration. All drawing elements are equal or similar to those of FIG. 7A, except for the gain element 310 where the gain material is surrounded by an additional transparent heat spreader 311. Like in the first configuration, the transparent heat spreaders are preferrably made from SiC and wafer-level contacted using direct bonding techniques, without adding an adhesion layer and without making any polishing step during the bonding process.

According to one embodiment, FIG. 9B shows an alternative 3-mirror configuration with elements corresponding to those discussed with respect to FIG. 9A.

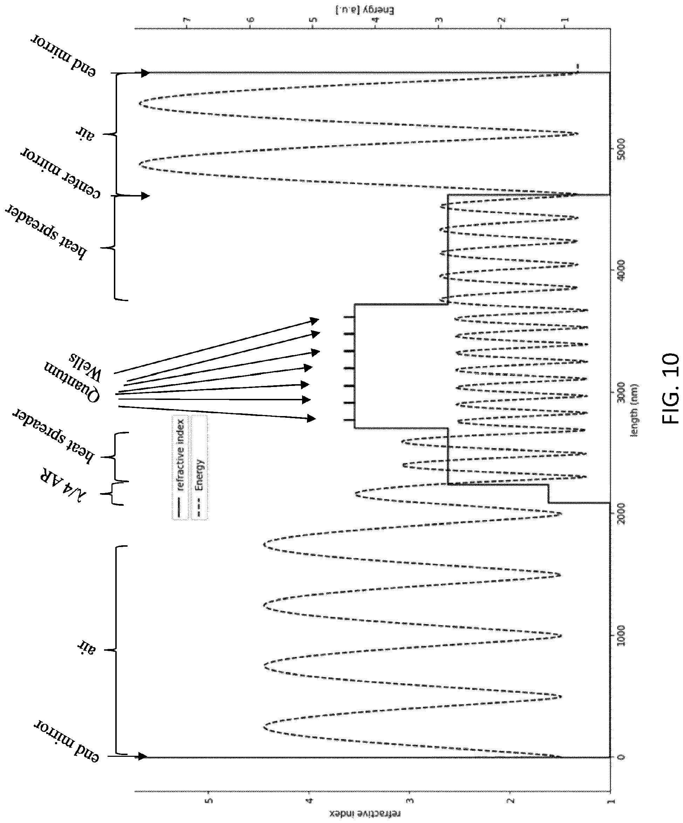

Similar to the simulation results plotted in FIG. 5, FIG. 6 and FIG. 8, the phase of the resonant radiation energy absolute value is shown in FIG. 10. Again, but located on the outer surface of one transparent heat spreader, the center mirror of the three-mirror cavity enforces an antinode at a fixed phase relationship to that mirror (a node in case of a simple Fresnel reflection). In this mode, the optical thickness of the second transparent heat spreader is important and needs to be controlled in order to optimize the standing wave phase inside the gain medium. A practical method of static optimization of the phase relationship between center mirror and quantum wells is temperature control. Since the SiC wafer thickness is not specified to meet a very tight tolerance, the optimum temperature needs to be found and set for each SiC wafer and operation condition.

Common to both variants of the MECSEL three-mirror cavity is that the center mirror reflectivity allows to adjust the quality ratio of the cavity parts on either side of the center mirror. Especially in laser configurations with low gain (compared to solid state or edge emitting semiconductor lasers), the three-mirror configuration allows the design of a laser cavity that has low loss on one side of the cavity and allows for relatively high loss in the other side. For instance, a MECSEL with about 5% gain can tolerate more than 10% loss, when the loss is observed in the cavity part opposite to the gain. In this example a center mirror with 30% reflectivity was implemented. In a standard two-mirror configuration, a laser with higher loss than gain would not operate.

The ideal condition of cavity transmission and width of the filter function is reached when

$$r_1 = \frac{r_m - r_2}{1 - r_m r_2}$$

Here, $r_1$ is the reflectivity coefficient of the longer cavity arm, $r_m$ is the center mirror reflectivity and $r_2$ is the shorter cavity arm reflectivity coefficient. This simplified formula ignores the gain of the quantum wells.

Preferred Laser Setups based on Configurations (A) and (B)

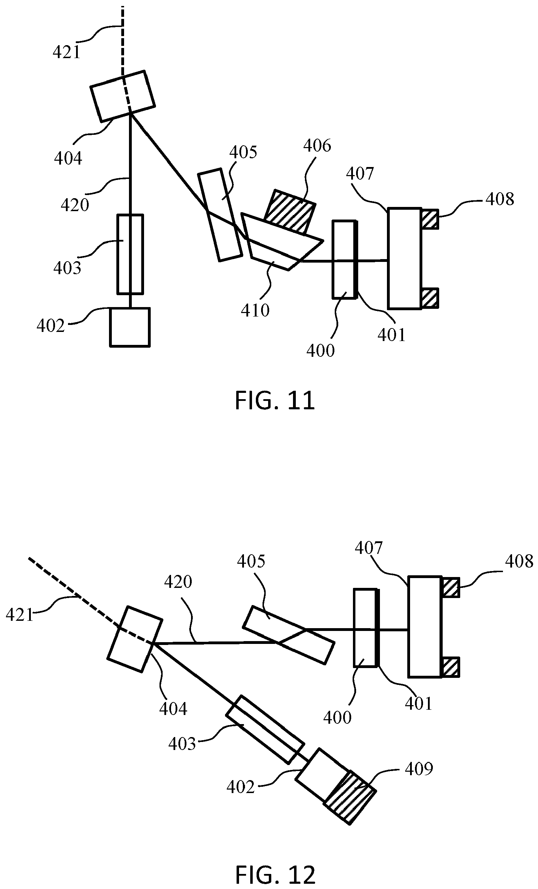

Both configurations (A) and (B) can be utilized in these practical laser resonator setups as shown in FIG. 11 and FIG. 12: A cavity formed from two end mirrors 402 and 407, and a dichroic routing mirror 404 that does not contribute to the phase relations of the resonant laser beam 420. The gain element 400 with a mirror surface 401 is held in a heatsink (not shown on the sketches) and the mirror surface 401 is at normal angle of incidence with respect to the resonant laser beam 420. A fraction 421 of that beam is coupled out of the cavity by the dichroic routing mirror 404.

(1) Additional Filter

Since the gain bandwidth of optically pumped semiconductors is very wide, typically further wavelength limiting elements are necessary. FIG. 12 depicts the effect of an additional filter, a Brewster birefringent filter (BiFi) in this example calculation. These filter elements might be set up as:

- birefringent filter 405 oriented at Brewster angle of incidence relative to the resonant laser radiation 420 (preferably made from crystalline quartz or YV0$_4$),
- (not depicted) non-Brewster oriented birefringent filter (preferably made from crystalline quartz or YVO$_4$ or nonlinear material used for intracavity frequency conversion 403, for instance BBO or LBO), in addition to further elements that filter a preferred polarization inside the laser cavity, preferably using optical surfaces oriented at Brewster orientation,
- (not depicted) a thin etalon (<100$\mu$m thickness) at an angle substantially exceeding the divergence angle of the resonant intra-cavity laser radiation,
- (not depicted) multi-layer dielectric optical filters, or
- (not depicted) volumetric Bragg grating mirrors.

(2) Length Control of a Cavity Distance

Stabilization of continuous single frequency operation by length control of one cavity distance from the center mirror of the three-mirror cavity with respect to one of the cavity end mirrors.

- In a preferred embodiment, the optical path length of one of these distances (end mirror to center mirror) is < 1/20 of the length of the total cavity length (end mirror to end mirror).

- In another preferred embodiment (not depicted), the optical path length ratio is not <1/20 and a volumetric Bragg grating is used as an end mirror 407.

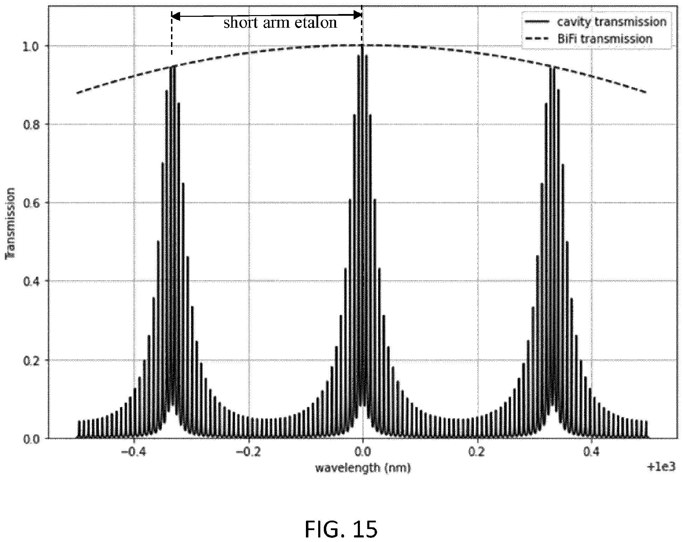

- In another preferred embodiment, the longer optical path length (from center mirror to either end mirror of the standing wave cavity) is not set to be an exact integer multiplied by the shorter path length, as this increases the losses for neighbored longitudinal modes. In case this multiplier is not an integer, adjacent transmission maxima, spaced apart by the etalon $\Delta f$ defined by the shorter cavity arm length, are not aligned with the resonances of the complete three mirror cavity. This is depicted in FIG. 15, where the center wavelength is in resonance with the short sub-cavity, while the next order transmissions, spaced apart by the short arm etalon, are not exactly aligned.

- In another preferred embodiment the shorter distance is being optimized by a dithering control loop, seeking highest efficiency of input pump power to output laser power.

- In another preferred embodiment, this control is being realized using a piezo-electric element 408 that modifies the distance of the end mirror of the shorter distance with respect to the center mirror.

- In another preferred embodiment (not depicted), this control is being realized using temperature control of a spacer between center mirror and the end mirror of the shorter distance.

(3) Tuning of the Single Frequency Laser Output Wavelength

In the configuration described in (2), the longer cavity length (from center mirror to cavity end mirror) can be varied to tune the resonant wavelength by:

- Moving a prism 410 (preferably configured having surfaces at Brewster angle with respect to the intracavity laser radiation), such that the optical path length through the prism is altered. In this case, the movement is performed with a piezo-electric element 406, as depicted in FIG. 11.

- Tuning the distance of the cavity end mirror 402 of the longer side of the cavity with respect to the center mirror 401. In this case, the movement is performed with a piezo-electric element 409, as depicted in FIG. 12.

### (4) External Frequency References

The length control of the longer cavity length (from center mirror to cavity end mirror) can be locked to external frequency references, such as:

- a dispersive grating spectrometer,
- a gas absorption line, using side-of-fringe or top-of-fringe techniques,
- a Fabry-Perot cavity (using for instance Pound-Drever-Hall or Hänsch-Couillaud techniques),
- a frequency reference created by Bragg interference (Volumetric Bragg Grating, Dielectric Bragg mirror(s)), or
- a Frequency Comb.

### (5) Intracavity Frequency Conversion

The three-mirror stabilized laser cavity can be equipped with optically nonlinear material 403 (birefringent phase matched, critically phase matched, or periodically poled nonlinear materials) to convert the resonant laser radiation 420 to different frequencies using:

- second harmonic generation (SHG, preferred configuration),
- difference frequency generation (using a second laser beam coupled to the nonlinear crystal (DFG), or
- optical parametric oscillation and amplification (OPO/OPA).

### (6) Three-mirror-MECSEL in Littrow Configuration

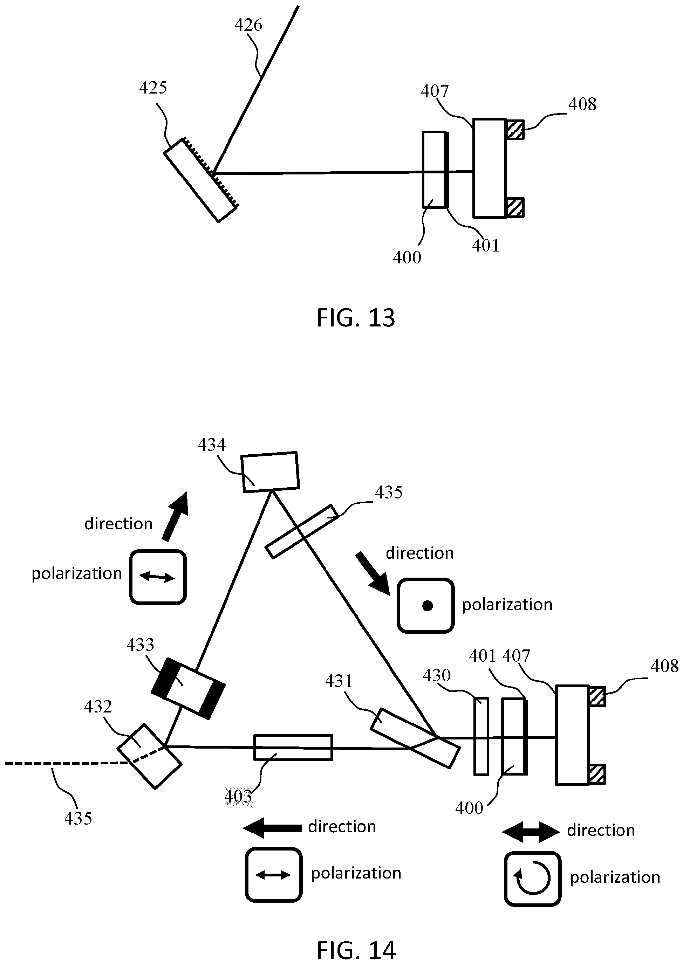

FIG. 13 depicts a three-mirror configuration where the cavity end reflector 425 is formed by a grating in Littrow configuration. The output beam 426 is coupled off the Littrow grating.

An alternative configuration would be a Littman-Metcalf setup of a three-mirror-MECSEL cavity (not depicted), as it has some nice features for wavelength tunability (mostly that the beam pointing remains constant with wavelength).

### (7) Three-Mirror-MECSEL in Hybrid Ring Cavity Configuration

As shown in FIG. 14, one (first) side of the three-mirror cavity is set up as a linear cavity as described above. By using a quarter-wave retarder 430 before this part of the cavity, a linear polarization entering this cavity side is transferred to a linear polarization at opposite direction after passing through the quarter-wave retarder, the gain chip 400, the intracavity reflector 401, the end mirror 407 and back through these elements. Using a polarizing splitting element 431 (this could be a birefringent crystal or a polarizing thin-film coating), a travelling wave ring cavity can be formed on the second part of the three-mirror cavity. In the example plotted, this part of the cavity is formed by two mirrors 432 and 434. Other configurations, using one mirror and a prism for example, are possible.

In this second part of the cavity, a Faraday polarization rotating element 433 tilts the polarization axis of the incoming beam. Since the direction of this polarization rotation is depending on the penetration direction through the element, the polarization rotation can be compensated by a half-wave retarder 435 in one direction through the ring-type sub-cavity. For light travelling into the opposite direction, the polarization rotation of the two elements 433 and 435 add up. For light travelling into the opposite direction, a significant portion is then reflected out of the resonator by the polarizing element 431. For all configurations but a 90° rotation of the rotating elements 433 and 435, this creates a significant loss for one direction through the ring cavity, while the other direction suffers less loss, so that uni-directional travel through the cavity is ensured. The ring cavity can be equipped with a nonlinear crystal (as described in (5)) to enable intracavity frequency conversion.

While the present disclosure describes at some length and with some particularity with respect to the several described embodiments, it is not intended that it should be limited to any such particulars or embodiments or any particular embodiment, but it is to be construed so as to provide the broadest possible interpretation in view of the related art and, therefore, to effectively encompass various embodiments herein. Furthermore, the foregoing describes various embodiments foreseen by the inventor for which an enabling description was available, notwithstanding that modifications of the disclosure, not presently foreseen, may nonetheless represent equivalents thereto.

### References

Ref. [1]: Michael Jetter, Roman Bek, Hermann Kahle, and Peter Michler "MECSEL: new concept for optically pumped semiconductor disk lasers with versatile wavelength (Conference Presentation)," Proc. SPIE 10682, Semiconductor Lasers and Laser Dynamics VIII, 1068213 (23 May 2018)
Ref. [2]: US 7,180,928
Ref. [3]: Benjamin Cocquelin, Gaëlle Lucas-Leclin, David Holleville, Noël Dimarcq, Isabelle Sagnes, et al., "Compact and Robust Single-frequencyDiode-pumped VECSEL at the Cesium D2 Line for Atomic Clocks," International Conference on Space Optics, Oct 2008, Toulouse, France. hal-00534717

Ref. [4]: PRIANTE, D., et al. "Demonstration of a 20 W membrane-external-cavity surface-emitting laser for sodium guide star applications," Electron. Lett, 2021, 57. Jg., S. 337.

Ref. [5]: Chris Hessenius, Pierre Yves Guinet, Michal Lukowski, Jerome Moloney, Mahmoud Fallahi, "589-nm single-frequency VECSEL for sodium guidestar applications," Proc. SPIE 8242, Vertical External Cavity Surface Emitting Lasers (VECSELs) II, 82420E

Ref. [6]: US 8,170,073

## Claims

1. A tunable laser operative in single longitudinal mode to emit tunable radiation over an output wavelength range, the tunable laser comprising:

   an optical cavity including a first end mirror (306), a second end mirror (307), and a center mirror (302);
   a quantum well gain region (301) interposed between the first and second end mirrors (306, 307); and
   a first transparent heat spreader (304) bonded to a first surface of the quantum well gain region (301);
   wherein the optical cavity is configured to generate resonant laser radiation between the first and second end mirrors (306, 307);
   wherein the quantum well gain region (301) comprises at least one quantum well (303) that is substantially aligned with an antinode of the resonant laser radiation and is located at a fixed distance to the center mirror (302);
   wherein an intra-cavity distance (308) from the first end mirror (306) to the center mirror (302) is kept at a resonance position to maintain maximum output power, and an intra-cavity distance (309) from the second end mirror (307) to the center mirror (302) is adjustable for tuning the laser to a desired output wavelength;
   wherein the center mirror is configured to maintain an antinode of the resonant radiation at a fixed phase relationship with the center mirror.

2. The tunable laser of claim 1, wherein the reflectivity of the center mirror is configured to cause an optical cavity loss on one side of the center mirror to be larger than an optical cavity loss on the other side of center mirror.

3. The tunable laser of claim 1, further comprising a filter element configured to limit the available output wavelength range:

   wherein the filter is a birefringent filter oriented at the Brewster angle of incidence relative to the resonant laser radiation, an etalon at an angle substantially exceeding a divergence angle of the resonant laser radiation, a multi-layer dielectric optical filter or volumetric Bragg grating.

4. The tunable laser of claim 1, further comprising a filter element configured to limit the available output wavelength range;
   wherein the filter is a non-Brewster oriented birefringent filter, and the tunable laser further comprises an optical element that filter a preferred polarization inside the optical cavity.

5. The tunable laser of claim 1, wherein the shorter distance from one of the end mirrors to the center mirror is less than 1/20 of the distance between the end mirrors.

6. The tunable laser of claim 1, wherein the longer distance from one of the end mirrors to the center mirror is an integer multiple of the shorter distance from the other one of the end mirrors to the center mirror.

7. The tunable laser of claim 1, wherein the shorter distance from one of the end mirrors to the center mirror is controlled by a dithering control loop, the control loop being configured to seek the highest efficiency of input pump power to output laser power.

8. The Tunable laser of claim 7, wherein the control is being realized by a piezo-electric element that modifies the distance of the end mirror of the shorter distance with respect to the center mirror, or by temperature control of a spacer between the center mirror and the end mirror of the shorter distance.

9. The tunable laser of claim 1, wherein the longer distance from one of the end mirrors to the center mirror is controlled by a moving prism, or by moving the end mirror associated with the longer distance.

10. The tunable laser of claim 1, wherein the longer distance from one of the end mirrors to the center mirror is locked to an external frequency reference, wherein the external frequency reference is a dispersive grating spectrometer, a gas absorption line, a Fabry-Perot cavity, a frequency reference created by Bragg interference, or a frequency comb.

11. The tunable laser of claim 1, further comprising a nonlinear element configured to convert the resonant laser radiation to different frequencies using second harmonic generation (SHG), difference frequency generation (DFG), or optical parametric oscillation and amplification (OPO/OPA).

12. The tunable laser of claim 1, wherein the optical cavity is further configured as a linear cavity part coupled to a ring cavity part via a polarization beam splitter;

wherein the linear cavity part comprises the quantum well gain region, center mirror and one of the end mirrors;

wherein a quarter-wave retarder is placed before the linear cavity and configured to receive a linear polarized light from the polarization beam splitter, and return the linear polarized light in reverse direction upon passing through the quarter-wave retarder, quantum well gain region and center mirror, reflected by the one of the end mirrors, and through the center mirror, quantum well gain region and quarter-wave retarder;

wherein the ring cavity part comprises the other one of the end mirrors and one or optical elements arranged in a ring pattern and configured to receive the polarized light from the polarization beam splitter, direct the light to loop through the other one of the end mirrors and the other optical elements and back to the polarization beam splitter.

13. The tunable laser of claim 1, further comprising a second transparent heat spreader (311) bonded to a second surface of the quantum well gain region (301);
wherein the center mirror (302) is located at a surface of the second transparent heat spreader (311) that interfaces to surrounding gas or mixture of gases.

14. The tunable laser of claim 1, further comprising a second transparent heat spreader (311) bonded to a second surface of the quantum well gain region (301);
wherein the center mirror (302) is located at a surface of the first transparent heat spreader (304) that interfaces to surrounding gas or mixture of gases.

15. The tunable laser of claim 1, wherein the intra-cavity distance from the first end mirror to the center mirror passes through a gas or mixture of gases, or the intra-cavity distance from the center mirror to the second end mirror passes through a gas or mixture of gases.

FIG. 1

FIG. 2

**FIG. 3**

**FIG. 4**

FIG. 5

FIG. 6

FIG. 7A

FIG. 7B

FIG. 9A

FIG. 9B

FIG. 8

FIG. 10

FIG. 11

FIG. 12

426

425

407

408

400 401

## FIG. 13

434

435

direction

polarization

direction

polarization

433

431 430 401 407 408

432

400

403

435

direction

polarization

direction

polarization

## FIG. 14

FIG. 15

| | Europäisches Patentamt European Patent Office Office européen des brevets | **EUROPEAN SEARCH REPORT** | Application Number EP 23 18 4367 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2013/250986 A1 (WUNDERER THOMAS [US] ET AL) 26 September 2013 (2013-09-26) * figure 8 * * paragraphs [0033] - [0037], [0045] - [0048] * ----- | 1-11,15 | INV. H01S5/14 H01S5/183 ADD. H01S3/08022 H01S3/08 |
| X | BURD S C ET AL: "Single-frequency 571nm VECSEL for photo-ionization of magnesium", PROCEEDINGS OF SPIE; [PROCEEDINGS OF SPIE ISSN 0277-786X VOLUME 10524], SPIE, US, vol. 9734, 2 June 2016 (2016-06-02), pages 973411-973411, XP060067331, DOI: 10.1117/12.2213398 ISBN: 978-1-5106-1533-5 * figures 2-4 * * 2. GAIN MIRROR DESIGN * * 3. LASER SETUP * * 5. FREQUENCY STABILIZATION * ----- | 1-3, 7-12,15 | H01S3/105 H01S3/109 H01S5/024 H01S5/04 H01S3/081 H01S3/082 H01S3/083 |
| X | US 2009/274177 A1 (FAN LI [US] ET AL) 5 November 2009 (2009-11-05) * figures 1, 10, 13 * * the corresponding description * ----- | 1,3,11, 15 | TECHNICAL FIELDS SEARCHED (IPC) H01S |
| X | RAJALA PATRIK ET AL: "Design and characterization of MECSELs for widely tunable (>25 THz) continuous wave operation", PROCEEDINGS OF THE SPIE, SPIE, US, vol. 11984, 4 March 2022 (2022-03-04), page 1198404, XP060154624, ISSN: 0277-786X, DOI: 10.1117/12.2610649 ISBN: 978-1-5106-5738-0 * the whole document * * figures 2, 4 * ----- -/-- | 1-3, 13-15 | |

The present search report has been drawn up for all claims

| Place of search | Date of completion of the search | Examiner |
|---|---|---|
| Munich | 17 November 2023 | Sauerer, Christof |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

Europäisches
Patentamt

European
Patent Office

Office européen
des brevets

## EUROPEAN SEARCH REPORT

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | KAHLE HERMANN ET AL: "MECSELs with direct emission in the 760 nm to 810 nm spectral range: a single- and double-side pumping comparison and high-power continuous-wave operation", SPIE PROCEEDINGS; [PROCEEDINGS OF SPIE ISSN 0277-786X], SPIE, US, vol. 10901, 5 March 2019 (2019-03-05), page 109010D, XP060118680, DOI: 10.1117/12.2512111 ISBN: 978-1-5106-3673-6 * the whole document * * figures 1, 2 * | 1-3, 13-15 | |
| A | GUINA M ET AL: "Optically pumped VECSELs: review of technology and progress", JOURNAL OF PHYSICS D: APPLIED PHYSICS, INSTITUTE OF PHYSICS PUBLISHING, BRISTOL, GB, vol. 50, no. 38, 23 August 2017 (2017-08-23), page 383001, XP020319659, ISSN: 0022-3727, DOI: 10.1088/1361-6463/AA7BFD [retrieved on 2017-08-23] * the whole document * | 1-15 | TECHNICAL FIELDS SEARCHED (IPC) |

The present search report has been drawn up for all claims

| Place of search | Date of completion of the search | Examiner |
|---|---|---|
| Munich | 17 November 2023 | Sauerer, Christof |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 23 18 4367

This annex lists the patent family members relating to the patent documents cited in  the above-mentioned European search report.
The members are as contained in the European Patent Office EDP file on
The European Patent Office is in no way liable for these particulars which are merely given for the purpose of information.

17-11-2023

| Patent document cited in search report | | Publication date | Patent family member(s) | | Publication date |
|---|---|---|---|---|---|
| US 2013250986 | A1 | 26-09-2013 | CN | 103326241 A | 25-09-2013 |
| | | | DE | 102013204964 A1 | 26-09-2013 |
| | | | GB | 2500491 A | 25-09-2013 |
| | | | JP | 6315887 B2 | 25-04-2018 |
| | | | JP | 2013197593 A | 30-09-2013 |
| | | | TW | 201345096 A | 01-11-2013 |
| | | | US | 2013250986 A1 | 26-09-2013 |
| US 2009274177 | A1 | 05-11-2009 | US | 2009274177 A1 | 05-11-2009 |
| | | | WO | 2007081688 A2 | 19-07-2007 |

EPO FORM P0459

For more details about this annex : see Official Journal of the European Patent Office, No. 12/82

# REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 63389809
- US 63340164
- US 7180928 B
- US 8170073 B

**Non-patent literature cited in the description**

- **MICHAEL JETTER ; ROMAN BEK ; HERMANN KAHLE ; PETER MICHLER.** MECSEL: new concept for optically pumped semiconductor disk lasers with versatile wavelength (Conference Presentation). *Proc. SPIE 10682, Semiconductor Lasers and Laser Dynamics VIII,* 23 May 2018, 1068213
- **BENJAMIN COCQUELIN ; GAËLLE LUCAS-LECLIN ; DAVID HOLLEVILLE ; NOËL DIMARCQ ; ISABELLE SAGNES et al.** Compact and Robust Single-frequencyDiode-pumped VECSEL at the Cesium D2 Line for Atomic Clocks. *International Conference on Space Optics,* October 2008

- **PRIANTE, D. et al.** Demonstration of a 20 W membrane-external-cavity surface-emitting laser for sodium guide star applications. *Electron. Lett,* 2021, vol. 57, 337
- **CHRIS HESSENIUS ; PIERRE YVES GUINET ; MICHAL LUKOWSKI ; JEROME MOLONEY ; MAHMOUD FALLAHI.** 589-nm single-frequency VECSEL for sodium guidestar applications. *Proc. SPIE 8242, Vertical External Cavity Surface Emitting Lasers (VECSELs) II,* 82420E